**Europäisches Patentamt**

**European Patent Office**

**Office européen des brevets**

(11) Veröffentlichungsnummer: **0 100 484**
**B1**

# EUROPÄISCHE PATENTSCHRIFT

(45) Veröffentlichungstag der Patentschrift:
08.01.86

(51) Int. Cl.⁴: **G 11 B 5/64**

(21) Anmeldenummer: **83107085.9**

(22) Anmeldetag: **20.07.83**

(54) **Verfahren zur Herstellung von Cobalt-epitaxial-beschichteten Eisenoxiden für die Magnetaufzeichnung.**

(30) Priorität: **31.07.82 DE 3228659**

(43) Veröffentlichungstag der Anmeldung:
**15.02.84 Patentblatt 84/7**

(45) Bekanntmachung des Hinweises auf die Patenterteilung:
**08.01.86 Patentblatt 86/2**

(84) Benannte Vertragsstaaten:
**BE DE FR GB IT NL**

(56) Entgegenhaltungen:
**EP - A - 0 035 633**
**AT - B - 367 226**
**DE - A - 2 743 298**
**DE - A - 2 909 995**
**US - A - 2 885 366**

(73) Patentinhaber: **BAYER AG, Konzernverwaltung RP Patentabteilung, D-5090 Leverkusen 1 Bayerwerk (DE)**

(72) Erfinder: **Kiemle, Peter, Dr., Bärenstrasse 53, D-4150 Krefeld-Traar (DE)**
Erfinder: **Wiese, Jürgen, Dr., Husarenallee 1, D-4150 Krefeld 1 (DE)**
Erfinder: **Buxbaum, Gunter, Dr., Holzapfelweg 2, D-4150 Krefeld-Traar (DE)**

ACTORUM AG

## Beschreibung

Die vorliegende Erfindung betrifft ein Verfahren zur Herstellung von magnetischen Cobalt-epitaxial-beschichteten Eisenoxiden mit erhöhter Koerzitivkraft.

$\gamma$-$Fe_2O_3$-Magnetpigmente besitzen Koerzitivkräfte bis etwa 380 Oe, $Fe_3O_4$-Magnetpigmente bis etwa 410 Oe. Für die Anwendung zur magnetischen Signalaufzeichnung im Audio-, Video- und Datenspeicherungsbereich werden zunehmend Magnetpigmente mit wesentlich höherer Koerzitivfeldstärke verlangt.

Zur Erhöhung der Koerzitivfeldstärke magnetischer Eisenoxide sind verschiedene Verfahren bekannt:

Gemäss der DE-A Nr. 2903593 erhält man höher koerzitive Pigmente aus $\alpha$-FeOOH-Vorläuferverbindungen, die mit Cobalt dotiert sind. Dabei erreicht man durch 1,0% Cobalt und einen FeO-Gehalt von 20% eine Koerzitivfeldstärke von etwa 620 Oe. Als nachteilig haben sich bei diesen Pigmenten die niedrige Kopierdämpfung und die ungenügende magnetische Stabilität erwiesen.

Ein anderer Weg, zu hohen Koerzitivfeldstärken zu gelangen, ist in der DE-A Nr. 2235383 beschrieben. Dabei lässt man auf einen Kern aus magnetischem Eisenoxid in stark alkalischem Milieu eine Schicht von Cobaltferrit epitaktisch aufkristallisieren. Diese Pigmente zeigen gegenüber den Cobalt-dotierten Pigmenten wesentlich bessere Werte für die Kopierdämpfung und sind magnetisch stabiler. Ein Nachteil dieser Pigmente ist, dass man zur Erreichung der gewünschten Koerzitivfeldstärke grosse Mengen des sehr teuren Elementes Cobalt benötigt.

In der DE-A Nr. 3038989 wird ein Verfahren beschrieben, bei dem das magnetische Eisenoxid in schwach alkalischem Medium in Wasser dispergiert wird. Anschliessend wird oberflächlich Cobalt abgeschieden. Die dabei erhaltenen Cobalt-beschichteten Eisenoxide haben eine höhere Koerzitivfeldstärke als solche Produkte, die in Wasser dispergiert werden, in dem schwach saure Bedingungen vorliegen (pH 4,2). Die erreichbare Koerzitivfeldstärkensteigerung und die mögliche Einsparung an Cobalt sind aber gering.

Die Aufgabe der vorliegenden Erfindung ist es daher, magnetische Eisenoxidpigmente mit höherer Koerzitivfeldstärke zur Verfügung zu stellen, die bei einem gleichen Cobalt-Gehalt nicht die obengenannten Nachteile aufweisen.

Überraschenderweise wurde nun gefunden, dass eine Säurebehandlung von epitaxial zu beschichtenden magnetischen Eisenoxiden diese Vorteile bringt.

Gegenstand der vorliegenden Erfindung ist somit ein Verfahren zur Herstellung von magnetischen epitaxial Cobalt-beschichteten Eisenoxiden mit erhöhter Koerzitivfeldstärke, wobei die zu beschichteten magnetischen Eisenoxide vor der Beschichtung einer Säurebehandlung unterzogen werden.

Dabei kann die Säurebehandlung vorteilhaft auf $\gamma$-$Fe_2O_3$, $Fe_3O_4$ oder bertholoiden Verbindungen mit einem FeO-Gehalt zwischen 0 und 30% erfolgen.

Diese Eisenoxide können dabei eines oder mehrere Begleitelemente aus der Gruppe P, Zn, B, Si, Sn, Ge, Al, Mn, Cr, Ni enthalten.

Besonders gute Ergebnisse werden erzielt, wenn die Begleitelemente Zink und/oder Phosphor sind.

Das zu beschichtende magnetische Eisenoxid wird vorzugsweise mit solchen Säuren oder Säuregemischen behandelt, die mit Eisen Komplexe bildende Säurereste enthalten. Besonders geeignete Säurereste sind dabei Chlorid und/oder Oxalat.

Die Säurekonzentration wird vorzugsweise zwischen 0,3 und 3 normal eingestellt, und das Eisenoxid wird bei Temperaturen von 10 bis 90° C so lange mit der Säure behandelt, bis der Gewichtsverlust, der bei der Säurebehandlung eintritt, 30% nicht überschreitet, vorzugsweise zwischen 5 und 20% liegt. Das magnetische Eisenoxid wird filtriert, gewaschen und anschliessend mit Cobaltferrit epitaktisch beschichtet.

Die Beschichtung mit Cobaltferrit kann gemäss der in der DE-A Nr. 2235383 beschriebenen Weise erfolgen. Ohne Nachteile lassen sich aber auch andere Arten zur epitaxialen Beschichtung anwenden.

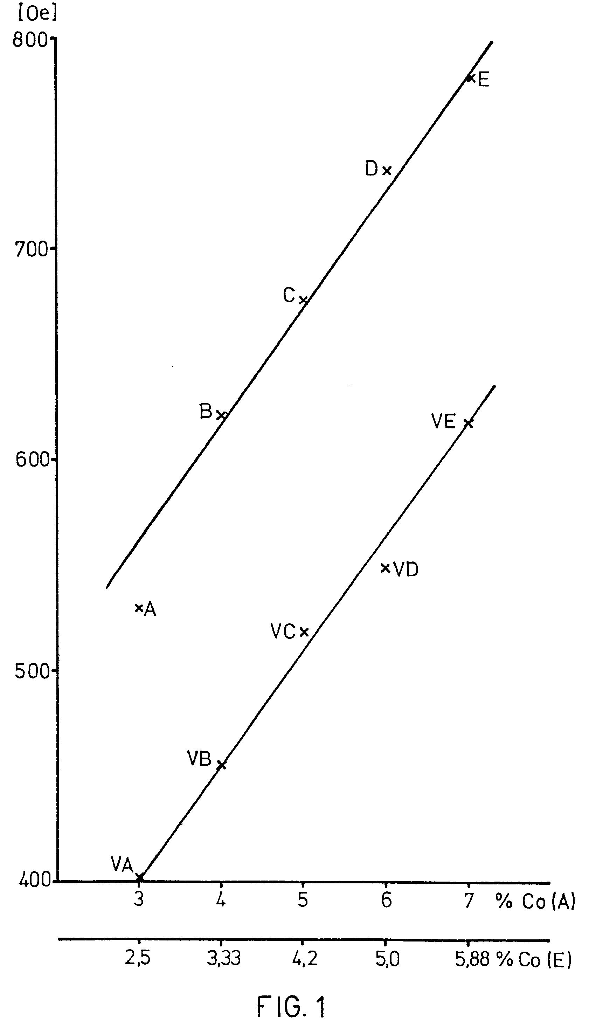

In Fig. 1 ist die Abhängigkeit der Koerzitivfeldstärke von der eingesetzten Menge Cobalt graphisch dargestellt. Dabei zeigt die obere Kurve (Punkte A bis E) die erfindungsgemäss behandelten Eisenoxide, die untere Kurve (Punkte VA bis VE) ein Material ohne Säurebehandlung. Als zu beschichtendes Material diente ein handelsübliches $\gamma$-$Fe_2O_3$-Magnetpigment (Bayferrox® 8220 M, Handelsprodukt der Bayer AG). Die Prozentangaben sind jeweils bezogen auf das Gewicht der Substanzen; % Co(A) ist die Menge Cobalt bezogen auf zu beschichtendes Produkt, % Co (E) auf das Endprodukt.

Aus dem Vergleich der Kurven in Fig. 1 ist die nach dem erfindungsgemässen Verfahren erzielte Verbesserung deutlich ersichtlich.

Zur Erreichung einer Koerzitivfeldstärke von 620 Oe, wie sie für die Anwendung in hochwertigen Audiobändern für den Arbeitspunkt II oder für Video-Aufzeichnungsbänder (½ Zoll) benötigt werden, waren nach dem bisherigen Stand der Technik etwa 7% Cobalt (bezogen auf das eingesetzte Ausgangsmaterial, entsprechend 5,88% Cobalt im fertigen Endprodukt) nötig. Nach dem erfindungsgemässen Verfahren kann diese Cobaltmenge um über 40% gesenkt werden.

Das die erfindungsgemässen Massnahmen zu diesen Erfolgen führen, muss als um so überraschender gewertet werden, als Säurebehandlungen von $\gamma$-$Fe_2O_3$ ohne anschliessende Cobaltferritbeschichtung keine Steigerung der Koerzitivfeldstärke bewirkt (EP-A Nr. 35633).

Gegenstand dieser Erfindung sind somit auch magnetische epitaxial Cobalt-beschichtete Eisenoxide, die nach den beschriebenen Verfahren hergestellt werden sowie deren Verwendung für die magnetische Signalaufzeichnung. Auch eignen sich die erfindungsgemässen Pigmente als Ausgangsmaterial für die Herstellung von hochwertigen Metallpigmenten.

Nachfolgend wird die Erfindung beispielhaft erläutert, ohne sie jedoch dadurch einzuschränken. Alle %-Angaben bedeuten Gewichts-%.

*Beispiel 1:*

480 g eines magnetischen $\gamma$-$Fe_2O_3$-Pigmentes (Handelsprodukt Bayferrox® 8220 M der Bayer AG; durchschnittliche Teilchenlänge 0,4 µm, Koerzitivfeldstärke 345 Oe) werden in einer Kotthoff-Mischsirene in 2400 ml Wasser aufgeschlämmt, anschliessend mit einer Kolloidmühle nass gemahlen, dann unter Rühren auf 50°C erwärmt und mit 491 ml konzentrierter Salzsäure (entsprechend 163 g HCl) versetzt. Nach 15 min Rühren wird abfiltriert und säurefrei gewaschen.

Cobaltferritbeschichtung: der mit Salzsäure behandelte Feststoff wird in so viel Wasser aufgeschlämmt, dass sich ein Feststoffgehalt von 150 g/l ergibt. Zu der Suspension werden nacheinander die in Tabelle I angegebenen Mengen $FeSo_4 \cdot 7H_2O$, $CoSO_4 \cdot 7H_2O$ und NaOH gegeben. Dabei wird die Menge an NaOH vor der Zugabe in so viel Wässer gelöst, dass sich eine Endfeststoffkonzentraion von 120 g/l einstellt.

*Tabelle I*

| Versuch | % Co bezogen auf Menge $\gamma$-$Fe_2O_3$ | $FeSO_4 \cdot 7H_2O$ (g) | $CoSO_4 \cdot 7H_2O$ (g) | NaOH (g) |
|---|---|---|---|---|
| A | 3 | 133,4 | 68,16 | 349,76 |
| B | 4 | 179,7 | 91,13 | 465,28 |
| C | 5 | 224,32 | 113,6 | 581,76 |
| D | 6 | 269,6 | 136,32 | 697,6 |
| E | 7 | 314,24 | 159,04 | 814,4 |

Die Suspension wird unter Rühren auf 80°C erhitzt und 6 h bei dieser Temperatur gehalten. Anschliessend wird der Feststoff filtriert, gewaschen und bei 30°C in einem Umlufttrockenschrank getrocknet.

*Beispiel 2 (Vergleichsbeispiel):*

480 g eines magnetischen $\gamma$-$Fe_2O_3$-Pigmentes

(wie im Beispiel 1) werden in einer Kotthoff-Mischsirene in 2400 ml Wasser aufgeschlämmt und anschliessend in einer Kolloidmühle nass gemahlen. Der Feststoff wird filtriert und entsprechend der in Beispiel 1 angegebenen Vorschrift der Cobaltferrit-Beschichtung unterzogen (Versuche VA bis VE).

*Tabelle II*

| Beispiel 1 | Koerzitivfeldstärke $I_HC$ (Oe) | Beispiel 2 | Koerzitivfelgstärke $I_HC$ (Oe) |
|---|---|---|---|
| A | 529 | VA | 402 |
| B | 620 | VB | 458 |
| C | 675 | VC | 518 |
| D | 736 | VD | 548 |
| E | 779 | VE | 617 |

**Patentansprüche**

1. Verfahren zur Herstellung von magnetischen epitaxial Cobalt-beschichteten Eisenoxiden mit erhöhter Koerzitivfeldstärke, dadurch gekennzeichnet, dass die zu beschichteten magnetischen Eisenoxide vor der Beschichtung einer Säurebehandlung unterzogen werden.

2. Verfahren gemäss Anspruch 1, dadurch gekennzeichnet, dass die zu beschichtenden Eisenoxide $\gamma$-$Fe_2O_3$, $Fe_3O_4$ oder eine bertholoide Verbindung mit einem FeO-Gehalt zwischen 0 und 30% sind.

3. Verfahren gemäss Anspruch 2, dadurch gekennzeichnet, dass die zu beschichtenden magnetischen Eisenoxide eines oder mehrere Begleitelemente aus der Gruppe P, Zn, B, Si, Sn, Ge, Al, Mn, Cr, Ni enthalten.

4. Verfahren gemäss Anspruch 3, dadurch gekennzeichnet, dass die Begleitelemente Zn und/ oder P sind.

5. Verfahren gemäss einem der Ansprüche 1 bis 4, dadurch gekennzeichnet, dass die Säuren mit Eisen Komplexebildende Säurereste enthalten.

6. Verfahren gemäss Anspruch 5, dadurch gekennzeichnet, dass die Säurereste Chlorid und/ oder Oxalat sind.

7. Verfahren gemäss den Ansprüchen 5 und 6, dadurch gekennzeichnet, dass die Säurekonzentration im Bereich von 0,3 bis 3 normal ist und die Säurebehandlung bei einer Temperatur zwischen 10 bis 90°C durchgeführt wird.

8. Verfahren gemäss einem der Ansprüche 1 bis 7, dadurch gekennzeichnet, dass die Säurebehandlung bis zu einem Gewichtsverlust des zu beschichtenden Eisenoxids von 2 bis 30%, bevorzugt 5 bis 20%, bezogen auf das Gewicht des zu beschichtenden Eisenoxids, durchgeführt wird.

9. Magnetische epitaxial Cobalt-beschichteten Eisenoxide erhältlich durch das Verfahren gemäss einem der Ansrpüche 1 bis 8.

10. Verwendung der magnetischen epitaxial Cobalt-beschichteten Eisenoxide gemäss den Ansprüche 1 bis 9 für die magnetische Signalaufzeichnung.

## Claims

1. Process for the production of magnetic iron oxides epitaxially coated with cobalt and having an increased coercive field strength, characterised in that the magnetic iron oxides to be coated are subjected to an acid treatment before being coated.

2. Process according to Claim 1, characterised in that the iron oxides to be coated are $\gamma$-$Fe_2O_3$, $Fe_3O_4$ or a bertholoid compound having an FeO content of between 0 and 30%.

3. Process according to Claim 2, characterised in that the magnetic iron oxides to be coated contain one or more accompanying elements from the group consisting of P, Zn, B, Si, Sn, Ge, Al, Mn, Cr and Ni.

4. Process according to Claim 3, characterised in that the accompanying elements are Zn and/or P.

5. Process according to one of Claims 1 to 4, characterised in that the acids contain acid radicals which form complexes with iron.

6. Process according to Claim 5, characterised in that the acid radicals are chloride and/or oxalate.

7. Process according to Claims 5 and 6, characterised in that the acid concentration is in the range of 0.3 to 3 normal and the acid treatment is carried out at a temperature of between 10 and 90°C.

8. Process according to one of Claims 1 to 7, characterised in that the acid treatment is carried out up to a weight loss of the iron oxide to be coated of 2 to 30%, preferably 5 to 20%, based on the weight of the iron oxide to be coated.

9. Magnetic iron oxides which are epitaxially coated with cobalt and which are obtainable by the process according to one of Claims 1 to 8.

10. Use of the magnetic iron oxides epitaxially coated with cobalt, according to Claims 1 to 9, for the magnetic recording of signals.

## Revendications

1. Procédé de préparation d'oxydes de fer magnétiques portant un revêtement épitaxial de cobalt à intensité de champ coercitif accrue, caractérisé en ce que l'on soumet les oxydes de fer magnétiques à revêtir, avant le traitement, à un traitement à l'acide.

2. Procédé selon la revendication 1, caractérisé en ce que les oxydes de fer à revêtir sont $\gamma$-$Fe_2O_3$, $Fe_3O_4$ ou un composé bertholoïde à une teneur en FeO de 0 à 30%.

3. Procédé selon la revendication 2, caractérisé en ce que les oxydes de fer magnétiques à revêtir contiennent un ou plusieurs éléments d'accompagnement du groupe consistant en P, Zn, B, Si, Sn, Ge, Al, Mn, Cr, Ni.

4. Procédé selon la revendication 3, caractérisé en ce que les éléments d'accompagnement sont Zn et/ou P.

5. Procédé selon l'une des revendications 1 à 4, caractérisé en ce que les acides contiennent des radicaux acides formant des complexes avec le fer.

6. Procédé selon la revendication 5, caractérisé en ce que les radicaux acides sont les radicaux chlorure et/ou oxalate.

7. Procédé selon les revendications 5 et 6, caractérisé en ce que la concentration de l'acide se situe dans l'intervalle de 0,3 à 3N et en ce que le traitement à l'acide est effectué à une température de 10 à 90°C.

8. Procédé selon l'une des revendications 1 à 7, caractérisé en ce que le traitement à l'acide est poursuivi jusqu'à une perte de poids de l'oxyde de fer à revêtir de 2 à 30%, de préférence de 5 à 20%, par rapport au poids de l'oxyde de fer à revêtir.

9. Oxydes de fer magnétiques portant un revêtement épitaxial de cobalt, obtenus par le procédé selon l'une des revendications 1 à 8.

10. Utilisation des oxydes de fer magnétiques portant un revêtement épitaxial de cobalt selon les revendications 1 à 9 pour l'enregistrement de signaux magnétiques.

FIG. 1